# EUROPEAN PATENT SPECIFICATION

(11) **EP 4 213 222 B1**
(45) Date of publication and mention of the grant of the patent: **18.06.2025**
(21) Application number: 22203410.0
(22) Date of filing: 24.10.2022
(51) Int. Cl.: H10F 19/80, H10F 19/85

(54) **LIGHTWEIGHT SOLAR POWER GENERATION PANEL AND PREPARATION METHOD THEREO**
LEICHTES SOLARSTROMERZEUGUNGSPANEEL UND HERSTELLUNGSVERFAHREN DAFÜR
PANNEAU LÉGER DE GÉNÉRATION D'ÉNERGIE SOLAIRE ET SON PROCÉDÉ DE FABRICATION

(30) Priority: 17.01.2022 CN 202210046406
(43) Date of publication of application: 19.07.2023
(73) Proprietor: Shenzhen Hello Tech Energy Co Ltd, Shenzhen City, Guangdong 518000 (CN)
(72) Inventor: ZHU, Yanjun, Shenzhen City, Guangdong 518000 (CN); LUO, Xiangwen, Shenzhen City, Guangdong 518000 (CN); YU, Huajun, Shenzhen City, Guangdong 518000 (CN); SUN, Zhongwei, Shenzhen City, Guangdong 518000 (CN)
(74) Representative: Dehns Germany Partnerschaft mbB

(56) References cited:
- CN-A- 111 564 513
- JP-B2- 6 365 057
- US-A1- 2012 073 623
- US-A1- 2018 097 134

## Description

### TECHNICAL FIELD

The present disclosure belongs to the technical field of solar cells and relates to a lightweight solar power generation panel and a method of preparing the same.

### BACKGROUND

Solar energy refers to the thermal radiation energy from the sun, which is mainly manifested as the sun rays as usually said. In modern times, solar energy is generally used to generate electricity or provide energy for solar water heaters. With the decrease of fossil fuels, solar energy has become an important part of the energy used by human beings and has been continuously developed. There are two ways to utilize solar energy: photothermal conversion and photoelectric conversion, and the solar power generation is an emerging technology to obtain renewable energy.

Because a single solar cell cannot be used directly as a power supply, solar photovoltaic modules emerge. The solar photovoltaic module is formed by connecting a plurality of single cells in series or in parallel and encapsulating the connected single cells. The solar photovoltaic module is the core part and the most important part of the solar power generation system, and the function of the solar photovoltaic module is to convert solar energy into electric energy, and then the electric energy can be stored in a storage battery, or drive the load to work.

For consumer-grade products for camping or hiking, such as solar power generation paper, solar power generation backpacks, solar chargers, portable solar power generation panels and the like, the portable solar cell panel must be ultra-light. Currently, there are two types of cell chip production technologies. The crystalline silicon solar cell panels used in products of large-scale power station systems, civil systems and street lamp systems are generally glass-encapsulated modules, and the crystalline silicon cell is difficult to promote deeply for civil products due to its physical characteristics of being heavy and hard.

CN207753022U discloses a solar photovoltaic module including a support frame and a solar cell panel installed on the support frame. The solar cell panel includes solar cell chips, and a plurality of solar cell chips are connected in series or in parallel through a photovoltaic cell lead and connected to the photovoltaic module through a lead. The solar cell chips are polycrystalline silicon cell chips. The solar photovoltaic module includes, from top to bottom, a front-panel, a first substrate, a first adhesive film layer, a solar cell panel, a second adhesive film layer, a second substrate and a baseplate. The solar photovoltaic module is formed by performing vacuum hot pressing on the front-panel, the first substrate, the solar cell panel, the second substrate and the baseplate. The outer cover of the solar photovoltaic module is provided with a flexible protective cover.

CN105047744A discloses a method of preparing a solar photovoltaic module. The method includes the following steps: providing a polytetrafluoroethylene ring on one surface of a first glass substrate; stacking a first encapsulation adhesive layer on the first glass substrate; arranging a solar cell chip in the middle of the first encapsulation adhesive layer, where the sum of thicknesses of the solar cell chip and the first encapsulation adhesive layer is less than a height of the polytetrafluoroethylene ring; stacking a second encapsulation adhesive layer on the solar cell chip, where the sum of thicknesses of the second encapsulation adhesive layer, the solar cell chip and the first encapsulation adhesive layer is greater than the height of the polytetrafluoroethylene ring; stacking a second glass substrate on the second encapsulation adhesive layer to obtain a semi-finished product; performing hot pressing on the semi-finished product, and housing the encapsulation layers in the polytetrafluoroethylene ring to obtain a laminate; removing the polytetrafluoroethylene ring, filling a curing adhesive, and performing curing to obtain the solar photovoltaic module.

CN208970522U discloses a solar photovoltaic module including a dielectric layer, a glass substrate, a first adhesive film layer, a cell layer, a second adhesive film layer and a back plate which are sequentially arranged from top to bottom, where bulges are distributed on a surface of the dielectric layer facing away from the glass substrate.

CN111564513A discloses a preparation method of a flexible photovoltaic module with high mechanical strength. The preparation method comprises the following steps: step(1), connecting a plurality of solarcells in series to form a solar cell array; step (2), sequentially stacking a polymer plate with a convex structure and a first packaging plate from bottom to top, enabling the convex structure to be downward, stacking the solar cell array completed in the step (1) and a second packaging plate, continuously stacking at least one layer of grid plate, and finally continuously stacking a polymer back plate; and step (3), overturning the laminated piece finished in the step (2) to enable the original upward surface to face downwards, putting the laminated piece into a laminating machine, and finishing a hot laminating process.

US2018/097134A1 discloses a lightweight solar module building materials set. The lightweight solar module building materials set may comprise a support assembly, at least one perforated plate, and at least one solar module. The support assembly includes a honeycomb structure and at least one supportive plate, wherein the honeycomb structure has multiple units each defining an inner space extending from a first side of the honeycomb structure to a second side of the honeycomb structure; the supportive plate is provided at the first side of the honeycomb structure. The perforated plate, which defines multiple perforations, is provided at the second side of the honeycomb structure, thus defining multiple sound absorption compartments between the honeycomb structure, the supportive plate and the perforated plate. The perforations of the perforated plate respectively communicate with the sound absorption compartments, so that sound waves can enter the sound absorption compartments via the perforations. The solar module includes at least one solar cell body, a flexible transparent protective layer, and at least one attachment part, wherein the protective layer can protect the solar cell body, the attachment part can attach the solar cell body and the protective layer to one side of the supportive plate that is away from the honeycomb structure, so that the solar cell body is disposed between the flexible transparent protective layer and the supportive plate.

US2012/073623A1 discloses a solar module having a six layer stack structure, including the following layers: (i) first plastic layer (e.g., ETFE layer); (ii) second plastic layer (e.g., uppermost EVA layer); (iii) solar cell layer; (iv) third plastic layer (e.g., intermediate EVA layer); (v) fiber panel; and (vi) fourth plastic layer (e.g., lowermost EVA layer). This six layer module is detachably attached to a seventh layer of rip stop backing material layer (or other pliable fabric).

The thin-film solar cells have the characteristics of light, flexibility, portability and the like and can be easily combined with various products, but the conversion efficiency is low. The higher the conversion efficiency of the solar cell panel is, the smaller the solar cell panel will be while still producing the output of the same power. To obtain a high-efficiency lightweight module, the crystalline silicon cell chips are still needed for chips, and the glass is usually replaced with a substrate with a smaller density. Since the processing of the solar products includes high-temperature hot pressing, the requirement for the temperature resistance performance of the lightweight substrate is extremely high, and applicative materials are very limited, thereby increasing the material cost and processing difficulty.

### SUMMARY

To overcome deficiencies in the related art, an object of the present disclosure is tc provide a lightweight solar power generation panel as defined in claim 1 and a method of preparing the sane as defined in claim 6. A low-density substrate material is used in the lightweight solar power generation panel provided by the present disclosure so that the entire solar power generation panel is lighter and portable.

To achieve this object, the present disclosure adopts the technical solutions below.

In a first aspect, the present disclosure provides a lightweight solar power generation panel. The lightweight solar power generation panel includes a substrate, an insulating layer, a cell layer and a support layer which are stacked in sequence.

A material of the substrate includes any one or a combination of at least two of polypropylene, polyvinyl chloride, polyethylene, polymethyl methacrylate, polycarbonate polystyrene or an acrylonitrile-butadiene-styrene copolymer.

The low-density substrate material is used in the lightweight solar power generation panel provided by the present disclosure, and a hollow structure is arranged on the substrate so that the weight of the substrate is reduced and the entire solar power generation panel is lighter and portable.

As a technical solution of the present disclosure, the substrate is provided with a plurality of through holes to form a hollow structure.

In the present disclosure, with the hollow structure provided on the substrate, the weight of the substrate can be further reduced so that the entire solar power generation panel is lighter.

According to the invention, a maximum width of a single through hole is less than or equal to 10 mm and for example, may be 1 mm, 2 mm, 3 mm, 4 mm, 5 mm, 6 mm, 7 mm, 8 mm, 9 mm or 10 mm. However, the maximum width of a single through hole is not limited to the listed values and other unlisted values within the preceding value range are also applicable.

According to the invention, a nearest distance between two adjacent through holes is greater than or equal to 1 mm and for example, may be 1 mm, 2 mm, 3 mm, 4 mm, 5 mm, 6 mm, 7 mm, 8 mm, 9 mm or 10 mm. However, the nearest distance between two adjacent through holes is not limited to the listed values, and other unlisted values within the preceding value range are also applicable.

The present disclosure has no specific requirement or special limitation on a shape of the through holes but has requirements on the size of the through holes and the nearest distance between the through holes. Since the substrate has the function of supporting and protecting the cell layer, the size of a hollowed single through hole cannot be too large, the maximum width of a single through hole is less than or equal to 10 mm, and the shortest distance between the through holes should be greater than or equal to 1 mm. Only in these size ranges can the effective strength be maintained on the premise of reducing the weight of the substrate.

Preferably, the through holes are circular through holes.

As a preferred technical solution of the present disclosure, a thickness of the substrate is 1-3 mm and for example, may be 1.0 mm, 1.2 mm, 1.4 mm, 1.6 mm, 1.8 mm, 2.0 mm, 2.2 mm, 2.4 mm, 2.6 mm, 2.8 mm or 3.0 mm. However, the thickness of the substrate is not limited to the listed values, and other unlisted values within the preceding value range are also applicable.

Similarly, in order to maintain the effective strength of the substrate on the premise of reducing the weight of the substrate, the present disclosure particularly defines that the thickness of the substrate is 1-3 mm. If the substrate is too thin, the substrate can be easily bent, causing deformation and damage to the cell layer, and if the substrate is too thick, the weight of the solar power generation panel is increased.

Preferably, a reinforcing member is provided on a surface of the substrate away from the insulating layer.

Since the opening of the substrate may cause a decrease in the strength of the substrate, in the present disclosure, the reinforcing member is provided on the substrate to increase the mechanical strength of the structure of the substrate. The present disclosure has no specific requirement and special limitation on a specific shape and an arrangement position of the reinforcing member. The reinforcing member may be a reinforcing rib, a prism or a binding, and the reinforcing member may be arranged around the substrate, may be evenly distributed on the surface of the substrate, or may be centrally arranged on the central region of the substrate.

Preferably, the reinforcing member is a reinforcing edge, and the reinforcing edge is provided along outer peripheral edges of a surface of the substrate.

Preferably, a height of the reinforcing edge is 1-3 mm and for example, may be 1.0 mm, 1.2 mm, 1.4 mm, 1.6 mm, 1.8 mm, 2.0 mm, 2.2 mm, 2.4 mm, 2.6 mm, 2.8 mm or 3.0 mm. However, the height of the reinforcing edge is not limited to the listed values, and other unlisted values within the preceding value range are also applicable.

As a preferred technical solution of the present disclosure, a weatherproof layer is further provided on a surface of the support layer away from the cell layer.

Preferably, a material of the weatherproof layer is ETFE (ethylene-tetrafluoroethylene, a copolymer).

Preferably, materials of the insulating layer and the support layer are PET (polyethylene terephthalate).

As a preferred technical solution of the present disclosure, an adhesive layer is provided between two adjacent layers, and the adhesive layer realizes bonding between layers.

As a preferred technical solution of the present disclosure, the cell layer includes a plurality of cell chips, the cell chips are connected in series or in parallel, and a positive electrode and a negative electrode are led out from the cell chips.

In a second aspect, the present disclosure provides a method of preparing the lightweight solar power generation panel according to the first aspect. The method includes the following steps:

performing string welding on a plurality of cell chips to obtain the cell layer, stacking the insulating layer, the cell layer and the support layer in sequence, performing high-temperature lamination on the stacked insulating layer, cell layer and support layer, and then bonding a substrate by low-temperature bonding on a surface of the insulating layer to obtain the lightweight solar power generation panel.

Since the substrate material adopted by the present disclosure is not resistant to high temperatures, the present disclosure also improves the method of preparing the lightweight solar power generation panel, and the material lamination is achieved by combining high-temperature hot pressing with low-temperature bonding. Hot pressing is only performed on the insulating layer, the cell layer, the support layer and the weatherproof layer in the high-temperature hot pressing process, the substrate does not need to be treated in a high-temperature laminator, and the semi-finished product obtained after the high-temperature lamination is bonded to the substrate under the low-temperature condition. In such preparation method, the temperature resistance requirement of the substrate is reduced, and the structure and shape of the material are no longer completely limited to the planar structure. Therefore, the applicable substrate has wider material scope, higher compatibility in shape and structure, and lower cost.

According to the present invention, a temperature of the high-temperature lamination is 140-160°C and for example, may be 140°C, 141°C, 142°C, 143°C, 144°C, 145°C, 146°C, 147°C, 148°C, 149°C, 150°C, 151°C, 152°C, 153°C, 154°C, 155°C, 156°C, 157°C, 158°C, 159°C or 160°C. However, the temperature of the high-temperature lamination is not limited to the listed values, and other unlisted values within the preceding value range are also applicable.

A time of the high-temperature lamination is 15-25 min and for example, may be 15 min, 16 min, 17 min, 18 min, 19 min, 20 min, 21 min, 22 min, 23 min, 24 min or 25 min. However, the time of the high-temperature lamination is not limited to the listed values, and other unlisted values within the preceding value range are also applicable.

A pressure of the high-temperature lamination is 0.05-0.1 MPa and for example, may be 0.05 MPa, 0.055 MPa, 0.06 MPa, 0.065 MPa, 0.07 MPa, 0.075 MPa, 0.08 MPa, 0.085 MPa, 0.09 MPa, 0.095 MPa or 0.1 MPa. However, the pressure of the high-temperature lamination is not limited to the listed values, and other unlisted values within the preceding value range are also applicable.

After the high-temperature lamination, cooling is performed on the obtained semi-finished product.

A time of the cooling is 8-15 min and for example, may be 8 min, 9 min, 10 min, 11 min, 12 min, 13 min, 14 min or 15 min. However, the time of the cooling is not limited to the listed values, and other unlisted values within the preceding value range are also applicable.

As a preferred technical solution of the present disclosure, in the method, the insulating layer, the cell layer, the support layer and a weatherproof layer are stacked in sequence, high-temperature lamination is performed on the stacked insulating layer, cell layer, support layer and weatherproof layer, and two adjacent sides are bonded by coating an adhesive.

The method further includes the following steps: performing an electrical performance test on the semi-finished product obtained after the high-temperature lamination, and trimming the semi-finished product which passes the test.

As a preferred technical solution of the present disclosure, the low-temperature bonding process of the substrate includes coating a ultraviolet (UV) adhesive on a surface of the support layer of the semi-finished product, bonding the semi-finished product to the substrate, and irradiating the UV adhesive with ultraviolet light at room temperature for light curing; or coating a hot-melt adhesive on a surface of the support layer of the semi-finished product, and bonding the semi-finished product to the substrate by low-temperature bonding.

In the conventional preparation method, various layers are stacked sequentially and then put into a laminator for high-temperature lamination. However, for the present disclosure, since the adopted substrate material is not resistant to high temperatures, adverse effects will be brought to the substrate by using the conventional preparation method. Therefore, the present disclosure adopts a two-step method to suit the substrate material. In the first step, layers other than the substrate are stacked and then put into the laminator for high-temperature lamination, and in the second step, the obtained semi-finished product is bonded to the substrate, where the bonding can be realized by light-curing a UV adhesive or low-temperature bonding.

A temperature of the low-temperature bonding is 90-140°C and for example, may be 90°C, 95°C, 100°C, 105°C, 110°C, 115°C, 120°C, 125°C, 130°C, 135°C or 140°C. However, the temperature of the low-temperature bonding is not limited to the listed values, and other unlisted values within the preceding value range are also applicable.

A time of the low-temperature bonding is 15-60 s and for example, may be 15 s, 20 s, 25 s, 30 s, 35 s, 40 s, 45 s, 50 s, 55 s or 60 s. However, the time of the low-temperature bonding is not limited to the listed values, and other unlisted values within the preceding value range are also applicable.

Compared with the related art, the present disclosure has the beneficial effects described below.

The low-density substrate material is used in the lightweight solar power generation panel provided by the present disclosure so that the entire solar power generation panel is lighter and portable. In addition, since the substrate material adopted by the present disclosure is not resistant to high temperatures, the present disclosure also improves the method of preparing the lightweight solar power generation panel, and the material lamination is achieved by combining high-temperature hot pressing with low-temperature bonding. Hot pressing is only performed on the insulating layer, the cell layer, the support layer and the weatherproof layer in the high-temperature hot pressing process, the substrate does not need to be treated in a high-temperature laminator, and the semi-finished product obtained after the high-temperature lamination is bonded to the substrate under the low-temperature condition. In such preparation method, the temperature resistance requirement of the substrate is reduced, and the structure and shape of the material are no longer completely limited to the planar structure. Therefore, the applicable substrate has wider material scope, higher compatibility in shape and structure, and lower cost.

### BRIEF DESCRIPTION OF DRAWINGS

FIG. 1 is a structure diagram of a lightweight solar power generation panel provided by an embodiment of the present disclosure;
FIG. 2 is a structure diagram of a substrate provided by an embodiment of the present disclosure;
FIG. 3 is a flowchart of the preparation of a lightweight solar power generation panel provided by an embodiment of the present disclosure.

In the drawings, 101-substrate; 102-first adhesive layer; 103-insulating layer; 104-second adhesive layer; 105-cell layer; 106-third adhesive layer; 107-support layer; 108-fourth adhesive layer; 109-weatherproof layer; 201-through holes; 202-reinforcing member.

### DETAILED DESCRIPTION

It is to be understood that in the description of the present disclosure, orientations or position relations indicated by terms such as "center", "longitudinal", "lateral", "upper", "lower" "front", "back", "left", "right", "vertical", "horizontal", "top", "bottom", "in" and "out" are those based on the drawings. These orientations or position relations are intended to facilitate and simplify the description of the present disclosure and not to indicate or imply that a device or element referred to must have a particular orientation or must be constructed or operated in a particular orientation. Thus, these orientations or position relations are not to be construed as limiting the present disclosure. In addition, terms such as "first" and "second" are used herein for purposes of description and are not to be construed as indicating or implying relative importance or implicitly indicating the number of technical features referred to. Thus, a feature defined by "first", "second" or the like may explicitly or implicitly include one or more of such features. In the description of the present disclosure, unless otherwise noted, the term "a plurality of" means two or more.

The technical solutions of the present disclosure are further described below through embodiments.

In an embodiment, the present disclosure provides a lightweight solar power generation panel. The lightweight solar power generation panel includes a substrate 101, an insulating layer 103, a cell layer 105 and a support layer 107 which are stacked in sequence.

A material of the substrate 101 includes any one or a combination of at least two of polypropylene, polyvinyl chloride, polyethylene, polymethyl methacrylate, polycarbonate, polystyrene or an acrylonitrile-butadiene-styrene copolymer.

The low-density substrate material is used in the lightweight solar power generation panel provided by the present disclosure so that the entire solar power generation panel is lighter and portable.

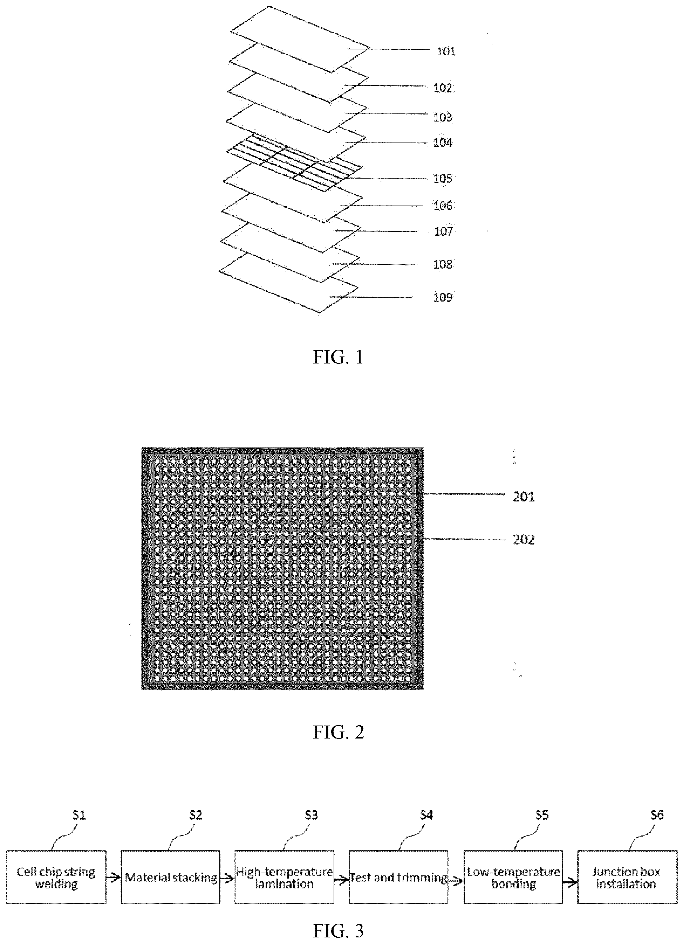

Furthermore, the substrate 101 is provided with a plurality of through holes 201 to form a hollow structure. The present disclosure has no specific requirement or special limitation on a shape of the through holes 201, and optionally, as shown in FIG. 2, the through holes 201 are circular through holes. However, the present disclosure has requirements on a size of the through holes 201 and a nearest distance between the through holes 201, a maximum width of a single through hole 201 is required to be less than or equal to 10 mm, and a nearest distance between two adjacent through holes 201 is greater than or equal to 1 mm. Since the substrate 101 has the function of supporting and protecting the cell layer 105, the size of a hollowed single through hole 201 cannot be too large, the maximum width of a single through hole 201 is less than or equal to 10 mm, and the shortest distance between the through holes 201 should be greater than or equal to 1 mm. Only in these size ranges can the effective strength be maintained on the premise of reducing the weight of the substrate 101.

Furthermore, a thickness of the substrate 101 is 1-3 mm. In order to maintain the effective strength of the substrate 101 on the premise of reducing the weight of the substrate 101, the present disclosure particularly defines that the thickness of the substrate 101 is 1-3 mm. If the substrate 101 is too thin, the substrate 101 can be easily bent, causing deformation and damage to the cell layer 105, and if the substrate 101 is too thick, the weight of the solar power generation panel is increased.

Furthermore, a reinforcing member 202 is provided on a surface of the substrate 101 away from the insulating layer 103. Since the opening of the substrate 101 may cause a decrease in the strength of the substrate 101, in the present disclosure, the reinforcing member 202 is provided on the substrate 101 to increase the mechanical strength of the structure of the substrate 101. The present disclosure has no specific requirement or special limitation on a specific shape and an arrangement position of the reinforcing member 202. The reinforcing member 202 may be a reinforcing rib, a prism or a binding, and the reinforcing member 202 may be arranged around the substrate 101, may be evenly distributed on the surface of the substrate 101, or may be centrally arranged on the central region of the substrate 101.

Optionally, as shown in FIG. 2, the reinforcing member 202 is a reinforcing edge, and the reinforcing edge is provided along outer peripheral edges of a surface of the substrate 101. A height of the reinforcing edge is 1-3 mm.

Furthermore, a weatherproof layer 109 is further provided on a surface of the support layer 107 away from the cell layer 105. A material of the weatherproof layer 109 may optionally be ETFE (ethylene-tetrafluoroethylene, a copolymer). Materials of the insulating layer 103 and the support layer 107 may optionally be PET (polyethylene terephthalate).

Furthermore, an adhesive layer is provided between two adjacent layers, and the adhesive layer realizes bonding between layers. Specifically, as shown in FIG. 1, a substrate 101, a first adhesive layer 102, an insulating layer 103, a second adhesive layer 104, a cell layer 105, a third adhesive layer 106, a support layer 107, a fourth adhesive layer 108 and a weatherproof layer 109 are stacked in sequence.

Furthermore, the cell layer 105 includes a plurality of cell chips, the cell chips are connected in series or in parallel, and a positive electrode and a negative electrode are led out from the cell chips.

In another embodiment, the present disclosure provides a method of preparing the lightweight solar power generation panel described in the preceding embodiments. As shown in FIG. 3, the method specifically includes steps S1 to S6 described below.

S1 cell chip string welding: cell chips are connected in a manner of series and parallel to form a group with a certain voltage and current, and a positive electrode and a negative electrode are led out to obtain the cell layer 105.

S2 material stacking: a high-temperature cloth is spread on a carrier, and from bottom to top, the weatherproof layer 109 (ETFE), the fourth adhesive layer 108, the support layer 107 (PET), the third adhesive layer 106, the cell layer 105, the second adhesive layer 104 and the insulating layer 103 (PET) are stacked on the carrier in sequence.

S3 high-temperature lamination: Teflon is arranged on a surface of the insulating layer 103 (PET) which is stacked uppermost to keep the surface clean and protect the surface from adhesive, the stacked layers are put into a laminator with the carrier for high-temperature lamination, where a temperature of the high-temperature lamination is 140-160°C, a time of the high-temperature lamination is 15-25 min and a pressure of the high-temperature lamination is 0.05-0.1 MPa, and after the high-temperature lamination, the obtained semi-finished product is cooled for 8-15 min.

S4 test and trimming: an electrical performance test is performed on the semi-finished product obtained after the high-temperature lamination, and the semi-finished product is trimmed which passes the test.

S5 low-temperature bonding: a UV adhesive is coated on the surface of the insulating layer 103 of the semi-finished product, the semi-finished product is bonded to the substrate 101, and the UV adhesive is irradiated with ultraviolet light at room temperature for light curing (the first adhesive layer 102 is formed after the UV adhesive is cured); or a hot-melt adhesive is coated on the surface of the insulating layer 103 of the semi-finished product, and the semi-finished product is bonded to the substrate by low-temperature bonding in a short time (the first adhesive layer 102 is formed after the hot-melt adhesive is cured), where a temperature of the low-temperature bonding is 90-140°C, and a time of the low-temperature bonding is 15-60 s.

S6 junction box installation: positive and negative electrode leads of the module are led out of the junction box.

Since the substrate material adopted by the present disclosure is not resistant to high temperatures, the present disclosure also improves the method of preparing the lightweight solar power generation panel, and the material lamination is achieved by combining high-temperature hot pressing with low-temperature bonding. Hot pressing is only performed on the insulating layer 103, the cell layer 105, the support layer 107 and the weatherproof layer 109 in the high-temperature hot pressing process, the substrate 101 does not need to be treated in a high-temperature laminator, and the semi-finished product obtained after the high-temperature lamination is bonded to the substrate 101 under the low-temperature condition. In such preparation method, the temperature resistance requirement of the substrate is reduced, and the structure and shape of the material are no longer completely limited to the planar structure. Therefore, the applicable substrate has wider material scope, higher compatibility in shape and structure, and lower cost.

### Example 1

This example provides a method of preparing a lightweight solar power generation panel. The preparation method specifically includes steps S1 to S6 described below.

S1 cell chip string welding: cell chips were connected in a manner of series and parallel to form a group with a certain voltage and current, and a positive electrode and a negative electrode were led out to obtain a cell layer 105.

S2 material stacking: a high-temperature cloth was spread on a carrier, and from bottom to top, a weatherproof layer 109 (ETFE), a fourth adhesive layer 108, a support layer 107 (PET), a third adhesive layer 106, the cell layer 105, a second adhesive layer 104 and an insulating layer 103 (PET) were stacked on the carrier in sequence.

S3 high-temperature lamination: Teflon was arranged on a surface of the insulating layer 103 (PET) which was stacked uppermost to keep the surface clean and protect the surface from adhesive, the stacked layers were put into a laminator with the carrier for high-temperature lamination, where a temperature of the high-temperature lamination was 140°C, a time of the high-temperature lamination was 25 min and a pressure of the high-temperature lamination was 0.05 MPa, and after the high-temperature lamination, the obtained semi-finished product was cooled for 8 min.

S4 test and trimming: an electrical performance test was performed on the semi-finished product obtained after the high-temperature lamination, and the semi-finished product was trimmed which passed the test.

S5 low-temperature bonding: a UV adhesive was coated on the surface of the insulating layer 103 of the semi-finished product, and the semi-finished product was bonded to a substrate 101, where the UV adhesive was irradiated with ultraviolet light at room temperature for light curing, and a first adhesive layer 102 was formed after the UV adhesive was cured.

S6 junction box installation: positive and negative electrode leads of the module were led out of the junction box.

### Example 2

This example provides a method of preparing a lightweight solar power generation panel. The preparation method specifically includes steps S1 to S6 described below.

S1 cell chip string welding: cell chips were connected in a manner of series and/or parallel to form a group with a certain voltage and current, and a positive electrode and a negative electrode were led out to obtain a cell layer 105.

S2 material stacking: a high-temperature cloth was spread on a carrier, and from bottom to top, a weatherproof layer 109 (ETFE), a fourth adhesive layer 108, a support layer 107 (PET), a third adhesive layer 106, the cell layer 105, a second adhesive layer 104 and an insulating layer 103 (PET) were stacked on the carrier in sequence.

S3 high-temperature lamination: Teflon was arranged on a surface of the insulating layer 103 (PET) which was stacked uppermost to keep the surface clean and protect the surface from adhesive, the stacked layers were put into a laminator with the carrier for high-temperature lamination, where a temperature of the high-temperature lamination was 145°C, a time of the high-temperature lamination was 23 min and a pressure of the high-temperature lamination was 0.06 MPa, and after the high-temperature lamination, the obtained semi-finished product was cooled for 10 min.

S4 test and trimming: an electrical performance test was performed on the semi-finished product obtained after the high-temperature lamination, and the semi-finished product was trimmed which passed the test.

S5 low-temperature bonding: a UV adhesive was coated on the surface of the insulating layer 103 of the semi-finished product, and the semi-finished product was bonded to a substrate 101, where the UV adhesive was irradiated with ultraviolet light at room temperature for light curing, and a first adhesive layer 102 was formed after the UV adhesive was cured.

S6 junction box installation: positive and negative electrode leads of the module were led out of the junction box.

### Example 3

This example provides a method of preparing a lightweight solar power generation panel. The preparation method specifically includes steps S1 to S6 described below.

S1 cell chip string welding: cell chips were connected in a manner of series and parallel to form a group with a certain voltage and current, and a positive electrode and a negative electrode were led out to obtain a cell layer 105.

S2 material stacking: a high-temperature cloth was spread on a carrier, and from bottom to top, a weatherproof layer 109 (ETFE), a fourth adhesive layer 108, a support layer 107 (PET), a third adhesive layer 106, the cell layer 105, a second adhesive layer 104 and an insulating layer 103 (PET) were stacked on the carrier in sequence.

S3 high-temperature lamination: Teflon was arranged on a surface of the insulating layer 103 (PET) which was stacked uppermost to keep the surface clean and protect the surface from adhesive, the stacked layers were put into a laminator with the carrier for high-temperature lamination, where a temperature of the high-temperature lamination was 150°C, a time of the high-temperature lamination was 20 min and a pressure of the high-temperature lamination was 0.08 MPa, and after the high-temperature lamination, the obtained semi-finished product was cooled for 12 min.

S4 test and trimming: an electrical performance test was performed on the semi-finished product obtained after the high-temperature lamination, and the semi-finished product was trimmed which passed the test.

S5 low-temperature bonding: a hot-melt adhesive was coated on the surface of the insulating layer 103 of the semi-finished product, and the semi-finished product was bonded to a substrate 101 by low-temperature bonding in a short time, and a first adhesive layer 102 was formed after the hot-melt adhesive was cured, where a temperature of the low-temperature bonding was 90°C, and a time of the low-temperature bonding was 60 s.

S6 junction box installation: positive and negative electrode leads of the module were led out of the junction box.

### Example 4

This example provides a method of preparing a lightweight solar power generation panel. The preparation method specifically includes steps S1 to S6 described below.

S1 cell chip string welding: cell chips were connected in a manner of series and parallel to form a group with a certain voltage and current, and a positive electrode and a negative electrode were led out to obtain a cell layer 105.

S2 material stacking: a high-temperature cloth was spread on a carrier, and from bottom to top, a weatherproof layer 109 (ETFE), a fourth adhesive layer 108, a support layer 107 (PET), a third adhesive layer 106, the cell layer 105, a second adhesive layer 104 and an insulating layer 103 (PET) were stacked on the carrier in sequence.

S3 high-temperature lamination: Teflon was arranged on a surface of the insulating layer 103 (PET) which was stacked uppermost to keep the surface clean and protect the surface from adhesive, the stacked layers were put into a laminator with the carrier for high-temperature lamination, where a temperature of the high-temperature lamination was 155°C, a time of the high-temperature lamination was 18 min and a pressure of the high-temperature lamination was 0.09 MPa, and after the high-temperature lamination, the obtained semi-finished product was cooled for 14 min.

S4 test and trimming: an electrical performance test was performed on the semi-finished product obtained after the high-temperature lamination, and the semi-finished product was trimmed which passed the test.

S5 low-temperature bonding: a hot-melt adhesive was coated on the surface of the insulating layer 103 of the semi-finished product, and the semi-finished product was bonded to a substrate 101 by low-temperature bonding in a short time, and a first adhesive layer 102 was formed after the hot-melt adhesive was cured, where a temperature of the low-temperature bonding was 110°C, and a time of the low-temperature bonding was 40 s.

S6 junction box installation: positive and negative electrode leads of the module were led out of the junction box.

### Example 5

This example provides a method of preparing the lightweight solar power generation panel. The preparation method specifically includes steps S1 to S6 described below.

S1 cell chip string welding: cell chips were connected in a manner of series and/or parallel to form a group with a certain voltage and current, and a positive electrode and a negative electrode were led out to obtain a cell layer 105.

S2 material stacking: a high-temperature cloth was spread on a carrier, and from bottom to top, a weatherproof layer 109 (ETFE), a fourth adhesive layer 108, a support layer 107 (PET), a third adhesive layer 106, the cell layer 105, a second adhesive layer 104 and an insulating layer 103 (PET) were stacked on the carrier in sequence.

S3 high-temperature lamination: Teflon was arranged on a surface of the insulating layer 103 (PET) which was stacked uppermost to keep the surface clean and protect the surface from adhesive, the stacked layers were put into a laminator with the carrier for high-temperature lamination, where a temperature of the high-temperature lamination was 160°C, a time of the high-temperature lamination was 15 min and a pressure of the high-temperature lamination was 0.1 MPa, and after the high-temperature lamination, the obtained semi-finished product was cooled for 15 min.

S4 test and trimming: an electrical performance test was performed on the semi-finished product obtained after the high-temperature lamination, and the semi-finished product was trimmed which passed the test.

S5 low-temperature bonding: a hot-melt adhesive was coated on the surface of the insulating layer 103 of the semi-finished product, and the semi-finished product was bonded to a substrate 101 by low-temperature bonding in a short time, and a first adhesive layer 102 was formed after the hot-melt adhesive was cured, where a temperature of the low-temperature bonding was 140°C, and a time of the low-temperature bonding was 15 s.

S6 junction box installation: positive and negative electrode leads of the module were led out of the junction box.

The applicant has stated that the above are only the embodiments of the present disclosure and not intended to limit the scope of the present disclosure. Those skilled in the art should understand that modifications or substitutions within the scope of the appended claims, all fall within the protection scope of the present disclosure.

## Claims

1. A lightweight solar power generation panel, comprising a substrate (101), an insulating layer (103), a cell layer (105) and a support layer (107) which are stacked in sequence;
**characterized in that** a material of the substrate (101) is any one or a combination of at least two of polymethyl methacrylate, polycarbonate, polystyrene or an acrylonitrile-butadiene-styrene copolymer; and
the substrate (101) is provided with a plurality of through holes (201) to form a hollow structure, a maximum width of a single through hole (201) is less than or equal to 10 mm, and a nearest distance between two adjacent through holes (201) is greater than or equal to 1 mm.

2. The lightweight solar power generation panel according to claim 1, wherein a thickness of the substrate (101) is 1-3 mm, a reinforcing member (202) is provided on a surface of the substrate (101) away from the insulating layer (103), the reinforcing member (202) is a reinforcing edge, the reinforcing edge is provided along outer peripheral edges of a surface of the substrate (101), and a height of the reinforcing edge is 1-3 mm.

3. The lightweight solar power generation panel according to claim 1, wherein a weatherproof layer (109) is further provided on a surface of the support layer (107) away from the cell layer (105), a material of the weatherproof layer (109) is ETFE, and materials of the insulating layer (103) and the support layer (107) are PET.

4. The lightweight solar power generation panel according to claim 1, wherein an adhesive layer (102, 104, 106, 108) is provided between two adjacent layers, and the adhesive layer (102, 104, 106, 108) realizes bonding between layers.

5. The lightweight solar power generation panel according to claim 1, wherein the cell layer (105) comprises a plurality of cell chips, the cell chips are connected in series or in parallel, and a positive electrode and a negative electrode are led out from the cell chips.

6. A preparation method of the lightweight solar power generation panel according to any one of claims 1-5, the preparation method comprising:
performing string welding (S1) on a plurality of cell chips to obtain the cell layer (105), stacking (S2) the insulating layer (103), the cell layer (105) and the support layer (107) in sequence, performing high-temperature lamination (S3) on the stacked insulating layer (103), cell layer (105) and support layer (107), and then bonding (S5) a substrate (101) by low-temperature bonding on a surface of the insulating layer (103) to obtain the lightweight solar power generation panel;
wherein a temperature of the high-temperature lamination is 140-160°C, a temperature of the low-temperature bonding is 90-140°C

7. The preparation method according to claim 6, wherein a time of the high-temperature lamination is 15-25 min, and a pressure of the high-temperature lamination is 0.05-0.1 MPa;
after the high-temperature lamination, cooling is performed on the obtained semi-finished product, and a time of the cooling is 8-15 min.

8. The preparation method according to claim 6, wherein the insulating layer (103), the cell layer (105), the support layer (107) and a weatherproof layer (109) are stacked in sequence, high-temperature lamination is performed on the stacked insulating layer (103), cell layer (105), support layer (107) and weatherproof layer (109), and two adjacent sides are bonded by coating an adhesive;
the method further comprises performing an electrical performance test (S4) on the semi-finished product obtained after the high-temperature lamination, and trimming the semi-finished product which passes the test.

9. The preparation method according to claim 6, wherein the low-temperature bonding process (S5) of the substrate (101) comprises coating a UV adhesive on a surface of the support layer (107) of the semi-finished product, bonding the semi-finished product to the substrate (101), and irradiating the UV adhesive with ultraviolet light at room temperature for light curing; or coating a hot-melt adhesive on a surface of the support layer (107) of the semi-finished product, and bonding the semi-finished product to the substrate (101) by low-temperature bonding, wherein a time of the low-temperature bonding is 15-60 s.

## Patentansprüche

1. Leichtes Solarenergieerzeugungspaneel, das ein Substrat (101), eine Isolierschicht (103), eine Zellschicht (105) und eine Trägerschicht (107) umfasst, die nacheinander gestapelt sind;
**dadurch gekennzeichnet, dass** ein Material des Substrats (101) eines oder eine Kombination von mindestens zwei der folgenden ist: Polymethylmethacrylat, Polycarbonat, Polystyrol oder ein Acrylnitril-Butadien-Styrol-Copolymer; und
das Substrat (101) mit einer Vielzahl von Durchgangslöchern (201) versehen ist, um eine hohle Struktur zu bilden, eine maximale Breite eines einzelnen Durchgangslochs (201) kleiner als oder gleich 10 mm ist und ein kleinster Abstand zwischen zwei benachbarten Durchgangslöchern (201) größer als oder gleich 1 mm ist.

2. Leichtes Solarenergieerzeugungspaneel nach Anspruch 1, wobei eine Dicke des Substrats (101) 1-3 mm beträgt, ein Verstärkungselement (202) auf einer Oberfläche des Substrats (101) entfernt von der Isolierschicht (103) vorgesehen ist, das Verstärkungselement (202) eine Verstärkungskante ist, die Verstärkungskante entlang äußerer Umfangskanten einer Oberfläche des Substrats (101) vorgesehen ist und eine Höhe der Verstärkungskante 1-3 mm beträgt.

3. Leichtes Solarenergieerzeugungspaneel nach Anspruch 1, wobei ferner eine wetterfeste Schicht (109) auf einer von der Zellschicht (105) entfernten Oberfläche der Trägerschicht (107) vorgesehen ist, ein Material der wetterfesten Schicht (109) ETFE ist und die Materialien der Isolierschicht (103) und der Trägerschicht (107) PET sind.

4. Leichtes Solarenergieerzeugungspaneel nach Anspruch 1, wobei eine Klebeschicht (102, 104, 106, 108) zwischen zwei benachbarten Schichten vorgesehen ist und die Klebeschicht (102, 104, 106, 108) das Verbinden zwischen den Schichten realisiert.

5. Leichtes Solarenergieerzeugungspaneel nach Anspruch 1, wobei die Zellschicht (105) eine Vielzahl von Zellchips umfasst, die Zellchips in Reihe oder parallel geschaltet sind und eine positive Elektrode und eine negative Elektrode aus den Zellchips herausgeführt sind.

6. Verfahren zur Herstellung eines leichten Solarenergieerzeugungspaneels nach einem der Ansprüche 1-5, wobei das Verfahren Folgendes umfasst:
Durchführen von Strangschweißen (S1) an einer Vielzahl von Zellchips, um die Zellschicht (105) zu erhalten, Stapeln (S2) der Isolierschicht (103), der Zellschicht (105) und der Trägerschicht (107) in Folge, Durchführen von Hochtemperatur-Laminierung (S3) an der gestapelten Isolierschicht (103), Zellschicht (105) und Trägerschicht (107), und dann Verbinden (S5) eines Substrats (101) durch Niedertemperatur-Bonden bzw. - Verbinden bzw. -Verkleben auf einer Oberfläche der Isolierschicht (103), um das leichtgewichtige Solarenergie-Erzeugungspanel zu erhalten;
wobei die Temperatur der Hochtemperatur-Laminierung 140-160°C und die Temperatur der Niedertemperatur-Verklebung 90-140°C beträgt.

7. Verfahren nach Anspruch 6, wobei die Dauer der Hochtemperaturlaminierung 15-25 Minuten und der Druck der Hochtemperaturlaminierung 0,05-0,1 MPa beträgt; wobei nach der Hochtemperaturlaminierung das erhaltene Halbzeug gekühlt wird, wobei die Kühlzeit 8-15 Minuten beträgt.

8. Verfahren nach Anspruch 6, bei dem die Isolierschicht (103), die Zellschicht (105), die Trägerschicht (107) und eine wetterfeste Schicht (109) nacheinander gestapelt werden, eine Hochtemperaturlaminierung auf der gestapelten Isolierschicht (103), Zellschicht (105), Trägerschicht (107) und wetterfesten Schicht (109) durchgeführt wird und zwei benachbarte Seiten durch Auftragen eines Klebstoffs verbunden werden; wobei das Verfahren ferner die Durchführung eines elektrischen Leistungstests (S4) an dem nach der Hochtemperaturlaminierung erhaltenen Halbzeug und das Beschneiden des Halbzeugs umfasst, das den Test besteht.

9. Verfahren nach Anspruch 6, wobei das Niedertemperaturbonden bzw. -kleben bzw. -verbinden (S5) des Substrats (101) das Auftragen eines UV-Klebstoffs auf eine Oberfläche der Trägerschicht (107) des Halbzeugs, das Verbinden des Halbzeugs mit dem Substrat (101) und das Bestrahlen des UV-Klebstoffs mit ultraviolettem Licht bei Raumtemperatur zur Lichthärtung umfasst; oder Auftragen eines Schmelzklebstoffs auf eine Oberfläche der Trägerschicht (107) des Halbfertigprodukts und Verbinden des Halbfertigprodukts mit dem Substrat (101) durch Niedertemperaturverbinden, wobei eine Zeit des Niedertemperaturverbindens 15-60 s beträgt.

## Revendications

1. Panneau léger de production d'énergie solaire, comprenant un substrat (101), une couche isolante (103), une couche de cellules (105) et une couche de support (107) qui sont empilées dans l'ordre ;
**caractérisé par le fait qu'**un matériau du substrat (101) est l'un quelconque ou une combinaison d'au moins deux des matériaux suivants : polyméthacrylate de méthyle, polycarbonate, polystyrène ou copolymère acrylonitrile-butadiène-styrène ; et
le substrat (101) est pourvu d'une pluralité de trous traversants (201) pour former une structure creuse, une largeur maximale d'un seul trou traversant (201) est inférieure ou égale à 10 mm, et une distance la plus proche entre deux trous traversants adjacents (201) est supérieure ou égale à 1 mm.

2. Panneau léger de production d'énergie solaire selon la revendication 1, dans lequel une épaisseur du substrat (101) est de 1 à 3 mm, un élément de renforcement (202) est prévu sur une surface du substrat (101) à l'écart de la couche isolante (103), l'élément de renforcement (202) est un bord de renforcement, le bord de renforcement est prévu le long des bords périphériques extérieurs d'une surface du substrat (101), et une hauteur du bord de renforcement est de 1 à 3 mm.

3. Panneau léger de production d'énergie solaire selon la revendication 1, dans lequel une couche étanche (109) est en outre prévue sur une surface de la couche de support (107) à l'écart de la couche de cellules (105), un matériau de la couche étanche (109) est l'ETFE, et les matériaux de la couche isolante (103) et de la couche de support (107) sont le PET.

4. Panneau léger de production d'énergie solaire selon la revendication 1, dans lequel une couche adhésive (102,104,106,108) est prévue entre deux couches adjacentes, et la couche adhésive (102,104,106,108) réalise le collage entre les couches.

5. Panneau léger de production d'énergie solaire selon la revendication 1, dans lequel la couche de cellules (105) comprend une pluralité de puces de cellules, les puces de cellules sont connectées en série ou en parallèle, et une électrode positive et une électrode négative sont dirigées vers l'extérieur des puces de cellules.

6. Procédé de préparation du panneau léger de production d'énergie solaire selon l'une quelconque des revendications 1 à 5, le procédé de préparation comprend :
effectuer un soudage par cordon (S1) sur une pluralité de puces cellulaires pour obtenir la couche cellulaire (105), empiler (S2) la couche isolante (103), la couche cellulaire (105) et la couche de support (107) dans l'ordre, effectuer un laminage à haute température (S3) sur la couche isolante (103), la couche cellulaire (105) et la couche de support (107) empilées, puis coller (S5) un substrat (101) par collage à basse température sur une surface de la couche isolante (103) pour obtenir le panneau léger de production d'énergie solaire ;
dans lequel une température du laminage à haute température est de 140-160°C, une température du collage à basse température est de 90-140°C.

7. Procédé de préparation selon la revendication 6, dans lequel la durée du laminage à haute température est de 15 à 25 minutes, et la pression du laminage à haute température est de 0,05 à 0,1 MPa ;
après le laminage à haute température, le produit semi-fini obtenu est refroidi pendant 8 à 15 minutes.

8. Procédé de préparation selon la revendication 6, dans lequel la couche isolante (103), la couche cellulaire (105), la couche de support (107) et une couche résistante aux intempéries (109) sont empilées dans l'ordre, un laminage à haute température est effectuée sur la couche isolante (103), la couche cellulaire (105), la couche de support (107) et la couche résistante aux intempéries (109) empilées, et deux côtés adjacents sont liés par l'enduction d'un adhésif ;
le procédé comprend en outre la réalisation d'un test de performance électrique (S4) sur le produit semi-fini obtenu après le laminage à haute température, et le rognage du produit semi-fini qui réussit le test.

9. Procédé de préparation selon la revendication 6, dans lequel l'opération de collage à basse température (S5) du substrat (101) consiste à enduire une colle UV sur une surface de la couche support (107) du produit semi-fini, à coller le produit semi-fini sur le substrat (101), et à irradier la colle UV avec une lumière ultraviolette à température ambiante pour la photopolymérisation ; ou enduire un adhésif thermofusible sur une surface de la couche de support (107) du produit semi-fini, et coller le produit semi-fini au substrat (101) par collage à basse température, dans lequel le temps de collage à basse température est de 15 à 60 s.
